Europäisches Patentamt

European Patent Office.

Office européen des brevets

(19)

(11) Numéro de publication: **0 329 507**
**A1**

(12) **DEMANDE DE BREVET EUROPEEN**

(21) Numéro de dépôt: **89400267.4**

(22) Date de dépôt: **31.01.89**

(51) Int. Cl.⁴: **H 01 L 39/22**
**H 01 L 39/12, H 01 L 39/24**

(30) Priorité: **02.02.88 FR 8801163**

(43) Date de publication de la demande:
**23.08.89 Bulletin 89/34**

(84) Etats contractants désignés: **DE GB IT NL**

(71) Demandeur: **THOMSON-CSF**
**51, Esplanade du Général de Gaulle**
**F-92800 Puteaux (FR)**

(72) Inventeur: **Creuzet, Gérard**
**THOMSON-CSF SCPI 19, avenue de Messine**
**F-75008 Paris (FR)**

**Hirtz, Jean-Pierre**
**THOMSON-CSF SCPI 19, avenue de Messine**
**F-75008 Paris (FR)**

(74) Mandataire: **Grynwald, Albert et al**
**THOMSON-CSF SCPI**
**F-92045 PARIS LA DEFENSE CEDEX 67 (FR)**

(54) **Dispositif en couches minces de matériau supraconducteur, et procédé de réalisation.**

(57) Dispositif en couches minces comportant au moins deux couches de matériaux ayant des caractéristiques électriques différentes et l'une des deux couches étant supraconductrices.

La couche supraconductrice (1) comporte une Terre Rare (ou de l'Yttrium) qui est choisie de façon à conférer des caractéristiques supraconductrices. L'autre couche (2) a une constitution qui diffère de celle de la couche supraconductrice par le fait seulement que la Terre Rare est différente et confère des propriétés électriques différentes.

FIG_3

EP 0 329 507 A1

Bundesdruckerei Berlin

**Description**

## DISPOSITIF EN COUCHES MINCES DE MATERIAU SUPRACONDUCTEUR ET PROCEDE DE REALISATION

L'invention concerne un dispositif en couches minces de matériau supraconducteur et son procédé de réalisation et plus particulièrement un dispositif en couches minces comportant au moins une couche mince supraconductrice.

Les jonctions Josephson sont les constituants de base de nombreux dispositifs supraconducteurs, dont les SQUID (Superconducting Quantum Interference Device), les mélangeurs, les corrélateurs, les mémoires supraconductrices, etc...).

La découverte de la supraconductivité à haute température critique Tc dans les oxydes de type $La_{2-x}Sr_xCuO_4-$ (Tc voisin de 30°K) puis $YBa_2Cu_3O_{7-y}$(Tc voisin de 90°K permet d'envisager la réalisation de jonctions Josephson possédant des températures de fonctionnement situées aux alentours de la température de l'azote liquide (77 °K Kelvins).

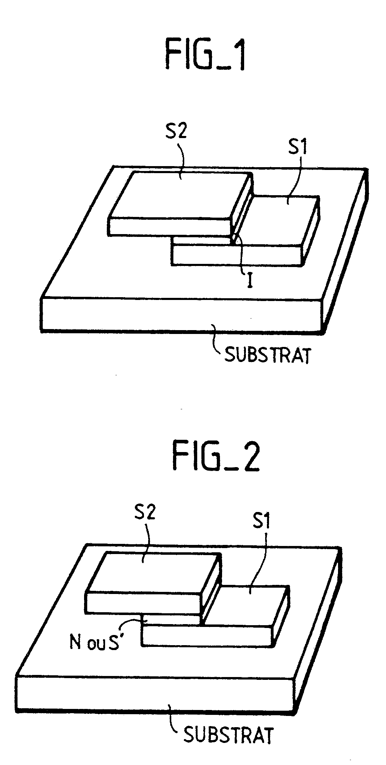

Dans les jonctions Josephson réalisées à partir de matériaux supraconducteurs à basse température critique Tc (Nb, Sn, Pb...) diverses technologies ont été étudiées (jonction à pointe, jonction à micropont ou à variation d'épaisseur). L'invention concerne l'adaptation aux nouveaux matériaux "haut-Tc" des technologies où un film très mince de matériau isolant, conducteur ou faiblement supraconducteur, sépare les deux électrodes de la jonction. Plus précisément, il s'agit des jonctions à effet tunnel Supraconducteur - Isolant Supraconducteur (SIS) et des jonctions en sandwich à effet de proximité Supraconducteur - Métal normal - Supraconducteur (SNS) ou Supraconducteur-Supraconducteur faible Supraconducteur (SS'S). Les figures 1 et 2 représentent de façon schématique ces différents types de jonctions.

Sur la figure 1, on trouve une jonction à effet tunnel comportant deux couches de matériaux supraconducteurs S1 et S2 séparées par une couche d'isolant I, l'ensemble étant disposé sur un substrat.

Sur la figure 2, on trouve une jonction en sandwich à effet de proximité comportant deux couches de matériaux supraconducteurs S1 et S2 séparées par une couche N ou S' d'un métal normal ou d'un matériau moins supraconducteur que les matériaux des couches S1 et S2, l'ensemble étant également disposé sur un substrat.

La contrainte majeure pour l'utilisation de ses technologies avec les nouveaux matériaux réside dans le fait que, pour obtenir le fonctionnement attendu de la structure Josephson ainsi constituée, il faut impérativement que la barrière séparant les deux électrodes supraconductrices ait une épaisseur de l'ordre de grandeur de la longueur de cohérence du matériau supraconducteur utilisé. Or, si cette longueur caractéristique était assez élevée (380 Angstroems pour le Niobium, 2300 Angstroems pour l'Etain, 830 Angstroems pour le Plomb,...) dans les Supraconducteurs à basse température critique Tc, elle n'est que de 34Angstroems selon l'axe le plus favorable, soit c, dans $YBa_2Cu_3O_{7-y}$ (et de 7 Angstroems selon les axes a et b), comme cela a été déterminé récemment par T.K. Worthington et al. dans l'article paru dans Physical Review Letters 59 (10), 1160 (1987).

La caractère supraconducteur des nouveaux matériaux oxydes est intimement lié à la structure, comme ceci a été démontré par de nombreux auteurs, et en particulier par R.J. Cava et al dans la Revue Physical Review Letters, 58 (16), 1676 (1987). Il est donc non seulement nécessaire de savoir réaliser un film d'une épaisseur de 20 Angstroems environ pour séparer les deux électrodes supraconductrices, mais il faut être capable, sur une distance d'une maille élémentaire environ, d'obtenir un matériau possédant la bonne structure de part et d'autre de cette barrière.

L'invention a donc pour objet une structure à base de matériaux supraconducteurs résolvant un tel problème, ainsi que son procédé de réalisation.

L'invention concerne donc un dispositif de matériau supraconducteur comprenant au moins deux couches, accolées l'une à l'autre, de matériaux de caractéristiques électriques différentes, caractérisé en ce que :

- une première couche en matériau supraconducteur possède une constitution déterminée et comporte au moins un élément Terre Rare (ou Yttrium) choisi de façon à ce que le matériau soit supraconducteur à température critique élevée ;

- une deuxième couche en matériau dont la constitution diffère de la constitution du matériau de la première couche par le fait seulement que l'élément Terre Rare est différent et est choisi de façon à ce que le matériau ait des caractéristiques électriques différentes de celles de la première couche (Isolant, Métal, ou Supraconducteur faible).

L'invention concerne également un procédé de réalisation d'un dispositif en couches minces de matériau supraconducteur comportant au moins une étape d'épitaxie d'une couche d'une matériau supraconducteur, l'un des constituants utilisés dans l'épitaxie étant une terre rare permettant d'obtenir un matériau supraconducteur, caractérisé en ce que durant l'étape d'épitaxie on prévoit au moins une phase durant laquelle la Terre Rare est remplacée par un constituant différent conférant au matériau obtenu durant cette phase des caractéristiques électriques différentes, la durée de cette phase étant telle que la couche obtenue a une épaisseur de quelques couches atomiques.

Les différents objets et caractéristiques de l'invention apparaîtront plus clairement dans la description qui va suivre, faite à titre d'exemple en se reportant aux figures annexées qui représentent :

- les figures 1 et 2, des exemples de réalisation de dispositifs connus dans la technique et déjà décrits précédemment ;

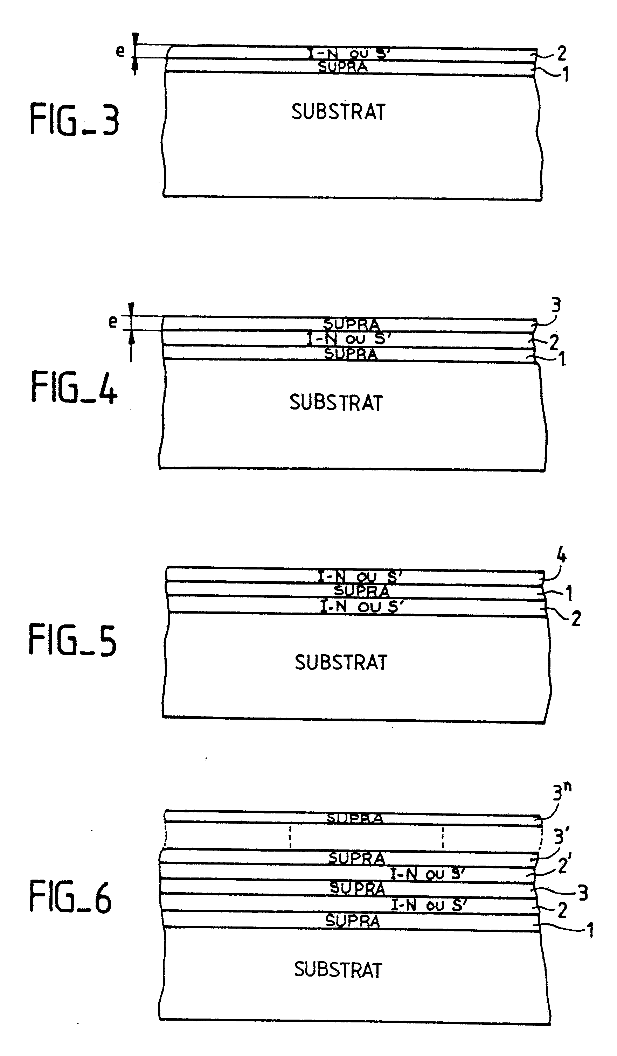

- les figures 3 à 5, différents exemples de réalisation d'un dispositif en couches minces de matériaux supraconducteur selon l'invention ;

   - la figure 6, un exemple de réalisation multi-couches selon l'invention.

Si l'on considère par exemple un matériau du type TR Ba$_2$Cu$_3$O$_{7-y}$ , où TR désigne soit de l'Yttrium Y, soit un élément de type Terre Rare, nous considérerons des substitutions sur les deux premiers éléments.

Les composés dans lesquels :
TR = Y, Yb, Tm, Er, Ho, Dy, Gd, Eu, ou Sm
sont supraconducteur avec des caractéristiques très voisines telles que par exemple la température critique peut être supérieure à 93 degrés K, et sont de structure Pérovskite comme cela est décrit dans le document de R.J. Cava et al cité précédemment.

Au contraire, quand TR = La ou Pr la structure est également la même, mais la supraconductivité n'est plus observée comme cela a été reporté par K.N. Yang et al dans l'article Solid State Com. 63 (6), 515 (1987).

Par ailleurs, B.R. Zhao et al ont reporté dans l'article Solid State Com. 63 (5), 409 (1987) que l'addition de scandium, en très petite quantité (> 0,35%) détruisait la supraconductivité dans le système YBa$_2$Cu$_3$O$_{7-y}$ le scandium étant substitué sur le site de l'Yttrium. Néanmoins, la possibilité de réaliser la substitution de cette façon est subordonnée à la possibilité de conserver la structure.

L'invention consiste donc à réaliser une structure telle que celle représentée en figure 3 dans laquelle une couche 1 de matériau supraconducteur est recouverte d'une couche 2 de matériau de caractéristiques électriques différentes, les deux couches étant différentes par la substitution d'un élément Terre Rare par un autre élément Terre Rare de façon que les deux matériaux aient la même structure. Par exemple, la couche 1 de matériau supraconducteur étant du type TR Ba$_2$Cu$_3$O$_{7-y}$ avec TR choisi de telle sorte que le matériau soit supraconducteur avec une température critique Tc élevée, on réalise la couche 2 par substitution de la terre rare TR par du Lanthane ou du Praséodyme ou par substitution d'une faible quantité de Scandium à la terre rare TR. On a alors une couche 2 d'un matériau possédant des propriétés métalliques et que l'on désigne dans la technique par l'appellation "métal normal", ou, comme cela est le cas sur la figure 3, par la lettre N.

On peut réaliser tout autre substitution avec d'autres matériaux, on obtient alors, selon la substitution :
- soit une couche 2 isolante (I sur la figure 3),
- soit une couche 2 de supraconductivité plus faible que celle de la couche 1 (S' sur la figure 3).

Les couches 1 et 2 sont des couches minces et, notamment, la couche 2 a une épaisseur e de quelques couches atomiques.

La figure 4 représente une structure selon laquelle deux couches 1 et 3 de matériau supraconducteur enserrent une couche 2 d'un matériau de caractéristique électrique différente de constitution identique à celle de la couche 2 de la figure 3. La couche 2 est alors soit isolante (I) soit métallique normal (N) soit faiblement supraconductrice (S').

La figure 5 représente une structure selon laquelle il s'agit d'une couche 1 de matériau supraconducteur qui est enserrée par deux couches 2 et 4 de matériau différent électriquement de la couche 1. Ces couches 2 et 4 sont similaires à la couche 2 de la structure de la figure 3. Elles peuvent être isolantes (I), métallique normal (N) ou faiblement supraconductrice (S'). Les deux couches 2 et 4 peuvent être différentes. Par exemple, la couche 2 peut être isolante (I) et la couche 4 faiblement supraconductrice (S') ou inversement.

La figure 6 représente une structure comprenant une alternance de couches supraconductrices (1, 3, 3',...n) et de couches (2, 2',...) en matériau électriquement différent du matériau supraconducteur. Ces couches (2, 2'...) peuvent ainsi être séparément soit isolantes, soit métalliques, soit faiblement supraconductrices.

Les couches minces d'oxydes supraconducteurs peuvent être élaborées par épitaxie par jets moléculaires comme cela a été décrit dans la demande de brevet français N° 87 09462 ayant pour titre : "Procédé de réalisation de dispositifs en couches minces de matériaux supraconducteurs et dispositifs réalisés par ce procédé" de G. CREUZET et A.FRIEDERICH. En effet, cette demande de brevet prévoit de réaliser de telles couches par épitaxie, sur un substrat, des différents éléments constituants en réglant l'admission des différents constituants pour obtenir une couche supraconductrice dont le paramètre de maille est sensiblement adapté à celui du substrat. L'épitaxie peut également se faire directement à partir d'un matériau supraconducteur.

Les structures décrites ci-dessus en relation avec les figures 3 à 6, peuvent être réalisées par interruption momentanée de la croissance par épitaxie par jets moléculaires du supraconducteur S lorsqu'on veut réaliser une couche non supraconductrice (I, N ou S'). Pour un supraconducteur, par exemple, de formule générale suivante :
TR Ba$_2$ Cu$_3$ O$_{7-y}$
où TR désigne une terre rare, les conditions sont modifiées de la façon suivante : dans le cas où TR est substitué par La ou Pr, on fermera pendant un temps correspondant à quelques couches atomiques la cellule de TR, et on ouvrira de manière synchronisée la cellule de La ou Pr. A la fin de cette phase, on réalisera l'opération inverse pour reprendre la croissance du supraconducteur afin de réaliser la seconde électrode.

Dans le cas de la substitution de très faibles quantités de Sc, on ouvrira la cellule de Sc en diminuant de façon simultanée la puissance de la cellule de TR afin de réaliser la substitution partielle dans les proportions désirées, où la quantité de Sc est minimisée afin de conserver la structure.

Toutefois, l'invention s'étend à tout procédé permettant de détruire ou de diminuer les propriétés supraconductrices d'un matériau tel que TR Ba$_2$Cu$_3$O$_{7-y}$ par modification chimique d'un ou plusieurs éléments en cours de croissance et sur quelques distances atomiques.

En particulier, le transport des éléments (Ba, Cu) sous forme de composé fluoré (BaF$_2$, CuF$_2$) conduisant à une occupation totale ou partielle des sites d'oxygène par le Fluor sans altération de la structure cristalline est incluse dans le procédé.

Par ailleurs, toutes les techniques d'ultra-vide permettant ce type de substitution, telle que le dopage planar, entrent dans le champ de l'invention. En l'occurence, le dopage planar consisterait par exemple à introduire une monocouche de Pr ou de La sur la surface du supraconducteur S, puis de reprendre l'épitaxie du supraconducteur sur cette monocouche.

Le procédé de l'invention s'étend aux structures en sandwich où plusieurs couches sont épitaxiées afin de réaliser ensuite des systèmes complexes de jonctions. On aboutit alors à des structures de type S - N - S - N - S - comme décrit sur la figure 6.

Le procédé de l'invention s'étend également à la possibilité de réaliser des couches d'encapsulation imperméables à l'oxygène par dessus les structures décrites précédemment. Les couches d'encapsulation sont similaires à celles décrites dans le brevet de G.CREUZET et A.FRIEDERICH, juillet 87, déjà décrit précédemment.

On voit que l'invention réside principalement dans le fait qu'une barrière en matériau non supraconducteur est réalisée par substitution de l'un des constituants du matériau supraconducteur sur quelques couches atomiques, ou de telle façon que les films très minces ainsi réalisés possèdent des propriétés électriques de type isolant, métal normal, ou supraconducteur faible.

On réalise une couche intermédiaire d'une jonction comportant une première électrode supraconductrice par substitution totale de TR par La ou Pr, ou par substitution de faible quantité de Sc à TR. Cette opération est réalisée sur quelques couches atomiques, et on reprend ensuite la croissance du matériau supraconducteur dans des conditions normales afin de réaliser une seconde électrode supraconductrice. Cette opération est réalisée avec une continuité de structure de part et d'autre de la barrière. Cette substitution (totale ou partielle) est de type planar car elle ne concerne que quelques plans atomiques.

Dans les trois cas considérés (substitution totale de TR par La ou Pr, ou partielle par Sc), le composé intermédiaire n'est pas supraconducteur mais possède des propriétés métalliques. La jonction est donc de type SNS. Toutefois, l'invention s'étend à toute substitution de même nature d'un autre élément pouvant conduire à une jonction de type SIS ou SS'S.

Il est bien évident que la description qui précède n'a été faite qu'à titre d'exemple non limitatif. D'autres variantes peuvent être envisagées sans sortir du cadre de l'invention. Les valeurs numériques n'ont été fournies uniquement que pour illustrer la description. Par ailleurs l'application de l'invention à une structure à base de supraconducteur du type $TR Ba_2Cu_3O_{7-y}$ n'a été fournie qu'à titre d'exemple.

**Revendications**

1. Dispositif en couches minces de matériau supraconducteur comprenant au moins deux couches, accolées l'une à l'autre, de matériaux de caractéristiques électriques différentes, caractérisé en ce que :
   - une première couche (1) en matériau supraconducteur possède une constitution déterminée et comporte au moins un élément Terre Rare (ou Yttrium) choisi de façon à ce que le matériau soit supraconducteur à température élevée ;
   - une deuxième couche (2) en matériau dont la constitution diffère de la constitution du matériau de la première couche (1) par le fait seulement que l'élément Terre Rare est différent et est choisi de façon à ce que le matériau ait des caractéristiques électriques différentes de celles de la première couche (1).

2. Dispositif en couches minces de matériau supraconducteur selon la revendication 1, caractérisé en ce qu'il comporte une troisième couche (3) de même constitution que celle de la première couche (1) et enserrant, avec cette première couche (1), la deuxième couche (2).

3. Dispositif en couches minces de matériau supraconducteur selon la revendication 1, caractérisé en ce qu'il comporte une quatrième couche (4) d'un matériau de constitution identique à celle du matériau de la deuxième couche et enserrant, avec cette deuxième couche (2) la première couche (1) de matériau supraconducteur.

4. Dispositif en couches minces de matériau supraconducteur selon la revendication 1, caractérisé en ce qu'il comporte une succession alternée de couches (1, 6, 8) d'un matériau de constitution similaire à celle du matériau supraconducteur de la première couche et de couches (2, 7, 9) d'un matériau de constitution similaire à celle du matériau de la deuxième couche.

5. Dispositif en couches minces de matériau supraconducteur selon la revendication 1, caractérisé en ce que l'élément terre rare de la deuxième couche (2) est du lanthane (La).

6. Dispositif en couches minces de matériau supraconducteur selon la revendication 1, caractérisé en ce que l'élément terre rare de la deuxième couche (2) est du praséodyme (Pr).

7. Dispositif en couches minces de matériau supraconducteur selon la revendication 1, caractérisé en ce que l'élément terre rare de la deuxième couche est remplacée en partie par du scandium.

8. Dispositif en couches minces de matériau supraconducteur selon la revendication 1, caractérisé en ce que le matériau de la première couche (1) est du type $TRBa_2Cu_3O_{7-y}$ où TR désigne un élément Terre Rare choisi de façon que cette première couche soit supraconductrice, la deuxième couche (2) étant également du type TR Ba$_2$Cu$_3$O$_{7-y}$ avec TR désignant également un élément Terre Rare choisi de façon que la deuxième couche ait des caractéristiques électriques différentes de celles de la première couche.

9. Procédé de réalisation d'un dispositif en couches minces de matériau supraconducteur selon l'une quelconque des revendications précédentes, comportant au moins une étape d'épitaxie d'une couche (1) d'un matériau supraconducteur, l'un des constituants utilisés dans l'épitaxie étant une Terre Rare permettant d'obtenir un matériau supraconducteur, caractérisé en ce que durant l'étape d'épitaxie on prévoit au moins une phase durant laquelle la Terre Rare est remplacée par un constituant différent conférant au matériau obtenu durant cette phase des caractéristiques électriques différentes, la durée de cette phase étant telle que la couche obtenue a une épaisseur atomique de quelques couches atomiques.

10. Procédé selon la revendication 9, caractérisé en ce que le constituant utilisé pour remplacer la Terre Rare est également une terre rare ne conférant pas de propriétés de supraconductivité au matériau épitaxié.

11. Procédé selon la revendication 10, caractérisé en ce que ledit constituant est du lanthane (La).

12. Procédé selon la revendication 10, caractérisé en ce que ledit constituant est du praséodyme (Pr).

13. Procédé selon la revendication 9, caractérisé en ce qu'il comporte plusieurs phases d'épitaxie dans lesquelles la terre rare est remplacée par un constituant différent, ces différentes phases étant séparées les unes des autres par une épitaxie du matériau supraconducteur comprenant une Terre Rare conférant des propriétés supraconductrices au matériau épitaxié.

## FIG_1

S2

S1

I

SUBSTRAT

## FIG_2

S2

S1

N ou S'

SUBSTRAT

FIG_3

FIG_4

FIG_5

FIG_6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,A | SOLID STATE COMMUNICATIONS, vol. 63, no. 6, 1987, pages 515-519, Pergamon Journals Ltd, Oxford, GB; K.N. YANG et al.: "High temperature superconductivity in rare-earth (R)-Barium copper oxides(RBa2)Cu3O9.delta" * En entier * --- | 1,5,6,8 ,11,12 | H 01 L  39/22 H 01 L  39/12 H 01 L  39/24 |
| D,A | SOLID STATE COMMUNICATIONS, vol. 63, no. 5, 1987, pages 409-410, Pergamon Journals Ltd, Oxford, GB; B.R. ZHAO et al.: "The effect of Sc on the superconductivity of the Ba-Y-Cu oxides" * En entier * --- | 1,7 | |
| A | JAPANESE JOURNAL OF APPLIED PHYSICS, vol. 26, no. 5, mai 1987, pages L815-L817, Tokyo, JP; S. OHSHIMA et al.: "Superconducting and structural properties of the new Ba1-xLnxCuO3-y compound system (Ln=La, Ce, Pr, Nd, Sm, Eu, Gd, Tb, Dy, Ho, Er and Yb) * En entier * --- | 1,5,6,8 ,11,12 | **DOMAINES TECHNIQUES RECHERCHES (Int. Cl.4)** H 01 L |
| A | APPLIED PHYSICS LETTERS, vol. 51, no. 7, 17 août 1987, pages 540-541, American Institute of Physics, New York, US; J. MORELAND et al.: "Josephson effect above 77 K in a YBaCuO break junction" * En entier * --- -/- | 1 | |

Le présent rapport a été établi pour toutes les revendications

| Lieu de la recherche | Date d'achèvement de la recherche | Examinateur |
|---|---|---|
| LA HAYE | 10-05-1989 | BAILLET B.J.R. |

Office européen
des brevets

**RAPPORT DE RECHERCHE EUROPEENNE**

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (Int. Cl.4) |
|---|---|---|---|
| D,A | PHYSICAL REVIEW LETTERS, vol. 59, no. 10, 7 septembre 1987, pages 1160-1163, The American Physical Society, New York, US; T.K. WORTHINGTON et al.: "Anisotropic nature of high-temperature superconductivity in single-crystal Y1Ba2Cu3O7-x"<br>--- | | |
| A | FR-A-2 469 005  (NIPPON TELEGRAPH & TELEPHONE PUBLIC CORP.)<br>* Page 2, ligne 20 - page 3, ligne 7 *<br>--- | 1 | |
| P,A | DE-A-3 810 243  (HITACHI LTD)<br>* Résumé; revendications *<br>----- | 1-13 | |
| | | | **DOMAINES TECHNIQUES RECHERCHES (Int. Cl.4)** |

Le présent rapport a été établi pour toutes les revendications

| Lieu de la recherche | Date d'achèvement de la recherche | Examinateur |
|---|---|---|
| LA HAYE | 10-05-1989 | BAILLET B.J.R. |

EPO FORM 1503 03.82 (P0402)